# EUROPÄISCHE PATENTSCHRIFT

(11) **EP 3 242 110 B1**
(45) Veröffentlichungstag und Bekanntmachung des Hinweises auf die Patenterteilung: **29.07.2020**
(21) Anmeldenummer: 17000587.0
(22) Anmeldetag: 07.04.2017
(51) Int. Cl.: G01D 4/02, G01R 11/25, H02H 5/00, G01R 22/06

(54) **ENERGIEZÄHLER MIT SENSOREN**
ENERGY METER WITH SENSORS
COMPTEUR ÉNERGÉTIQUE DOTÉ DE CAPTEURS

(30) Priorität: 20.04.2016 DE 102016004696
(43) Veröffentlichungstag der Anmeldung: 08.11.2017
(73) Patentinhaber: Seidl, Robert M., 6912 Hörbranz (AT)
(72) Erfinder: Seidl, Robert M., 6912 Hörbranz (AT)
(74) Vertreter: Riebling, Peter

(56) Entgegenhaltungen:
- DE-A1- 3 812 416
- US-A1- 2002 105 435
- US-A1- 2005 195 078
- US-A1- 2013 242 445

## Beschreibung

Die Erfindung betrifft einen Energiezähler mit Sensoren und gegebenenfalls mit einem Unterbrecher nach dem Oberbegriff des Patentanspruches 1.

Energiezähler mit Unterbrecher sind insbesondere auf dem amerikanischen Energieversorgermarkt bekannt. Beispielsweise wird auf die US 4,377,948 A, die US 2010/0264906 A1 oder die WO 2005/036186 A verwiesen.

Alle dort beschriebenen Energiezähler zeichnen sich dadurch aus, dass der mit dem Energiezähler verbundene Unterbrecher eine Unterbrechung der Stromversorgung dann ausführt, wenn ein bestimmtes Zählintervall überschritten ist.

Die US 4,377,948 A verwendet als Zählgröße den Gasverbrauch, den der Zähler erfasst und bei Überschreitung einer bestimmten vorgegebenen Gasmenge schaltet der Unterbrecher die Energieversorgung des Verbrauchers ab.

Mit der US 2010/0264906 A1 ist ein Energiezähler bekannt geworden, bei dem Energieverbrauchskurven verschiedener Verbraucher angelegt werden und bei Überschreitung bestimmter Energiemengen unterbricht der mit dem Zähler verbundene Unterbrecher die Stromversorgung zum Verbraucher.

In der WO 2005/036186 A1 wird der Energieverbrauch eines Verbrauchers mit einem geeigneten Sensor erfasst und bei Überschreitung eines vorgegebenen Energieverbrauches schaltet der Unterbrecher die Stromversorgung zum Verbraucher ab.

Die genannten Energiezähler mit Unterbrecher beschäftigen sich allerdings nicht mit dem Problem, dass bei Eintreten eines Störfalls auf der Verbraucherseite der Energieversorger die Möglichkeit haben sollte, die Energiezufuhr zum Verbraucher zu beschränken oder ganz einzustellen.

Es sind aus dem vorgenannten Stand der Technik auch zählerseitig eingebaute Unterbrecher bekannt, die bei Überschreitung einer bestimmten, vorgegebenen Temperatur den Zähler abschalten oder auf eine geringere Verbrauchsmenge für den Verbraucher zurückfahren, um den Leistungsverbrauch des Verbrauchers zu beschränken.

Als weiteres bekanntes Anwendungsfeld sind die sogenannten Smartmeter bekannt, die auch unter dem Begriff Smart grid den Stromverbrauch von elektrischen Anlagen erfassen und diesen mittels unterschiedlichster Übertragungstechnologien drahtgebunden oder drahtlos an den Energieversorger zurückmelden.

Ein weiteres Beispiel eines Zählers, der eine Abschaltung vornehmen kann, findet sich im Dokument US2005/0195078 A1, worin ein Zähler auf ein Warnsignal etwa von Sensoren reagiert, indem er beispielsweise die Gaszufuhr unterbricht. Der Zähler ist mittels eines Modems mit dem Energieversorger verbunden und kann diesen über die Störung unterrichten. Im Dokument US2013/0242445 wird ein Stromzähler beschrieben, der den Stromfluss und die Spannung überwacht, und bei Überschreiten von Grenzwerten die Stromzufuhr unterbricht, um den Verbraucher zu schützen. Die Störung wird an den Energieversorger übermittelt.

Bisher gibt es jedoch noch nicht die Möglichkeit, dass der Energieversorger im Fall einer Störung beim Verbraucher selbst auf den verbraucherseitigen Verbrauch Einfluss nehmen kann.

Der Erfindung liegt deshalb die Aufgabe zugrunde, einen Energiezähler mit Unterbrecher der eingangs genannten Art so weiterzubilden, dass auch der Energieversorger im Falle einer Störung auf der Verbraucherseite die Leistungsentnahme durch den Verbraucher einschränken oder ganz unterbrechen kann.

Zur Lösung der gestellten Aufgabe ist die Erfindung durch die technische Lehre des Anspruches 1 gekennzeichnet.

Merkmal der Erfindung ist, dass zur Erfassung mindestens einer Störgröße an oder im Zähler oder am oder im Verteilerschrank oder in der Nähe des Verteilerschrankes mindestens ein Sensor angeordnet ist, der eine Störgröße erfasst, die ein Kriterium für die Einschränkung der Leistungsentnahme auf der Verbraucherseite darstellt.

Der erfindungsgemäße Energiezähler kann jede beliebige Funktionsweise aufweisen, er ist beispielsweise als Drehstromzähler, Wechselstromzähler, als Wandlerzähler und dergleichen ausgebildet.

Der einfacheren Beschreibung wegen wird in der folgenden Beschreibung nur davon ausgegangen, dass derartige Sensoren zur Erfassung von Störgrößen entweder im Verteilerschrank oder im Energiezähler angeordnet sind, obwohl die Erfindung hierauf nicht beschränkt ist.

Es wurde erkannt, dass verschiedene verbraucherseitige Störgrößen als Abschaltkriterium geeignet sind. Dies gilt insbesondere für die Überschreitung einer Temperatur am oder im Energiezähler, die Überschreitung der Feuchte am oder im Energiezähler, die Überschreitung einer Gasmenge im Umgebungsbereich des Energiezählers oder des Verteilerschrankes oder im Verteilerschrank selbst. Ebenso kann als weitere Störgröße die Anwesenheit eines bestimmten Gases und/oder die Art der Gaszusammensetzung im Umgebungsbereich des Energiezählers oder des Verteilerschrankes verwendet werden.

Wichtig ist, dass alle Störgrößen von einer zählerseitigen Auswerteelektronik erfasst und dort entsprechend ihrem bewerteten Störeinfluss ausgewertet werden. Dem Energieversorger wird dann über eine drahtlose oder drahtgebundene Signalverbindung diese Störgröße mitgeteilt, und dieser kann über eine drahtgebundene oder eine drahtlose Kommunikationsleitung den Unterbrecher im verbraucherseitigen Energiezähler ansteuern, um so die Zufuhr weiterer Stromenergie zum Energiezähler zu unterbinden oder mindestens einzuschränken.

Somit ist es erstmals möglich, dass der Energieversorger selbst bei Ausbruch eines Brandes, bei unzulässiger Temperaturerhöhung, bei Gasentwicklung, bei Überschwemmung oder anderen Naturereignissen oder Störgrößen Einfluss auf die Energieentnahme auf der Verbraucherseite nehmen kann.

Nach dem Gegenstand des unabhängigen Anspruches 1 ist es vorgesehen, dass im oder am Energiezähler ein Unterbrecher angeordnet ist, der direkt von dem Energieversorger ansteuerbar ist.

Nach der technischen Lehre eines nicht unter die Ansprüche fallenden Beispiels ist es jedoch vorgesehen, dass der Unterbrecher auch entfallen kann und stattdessen lediglich beim Energieversorger eine Alarmmeldung generiert wird, die auf verschiedenen Signalpfaden an den Verbraucher weitergeleitet werden kann.

In einer ersten Ausführungsform ist es bei dieser Idee vorgesehen, dass die Alarmmeldung an den Verbraucher über eine Internetverbindung mitgeteilt wird, wobei vorausgesetzt wird, dass der Energieversorger eine Internetseite vorhält, auf der entsprechende Alarmmeldungen erkennbar sind, die für den Verbraucher abfragbar sind.

Eine andere Möglichkeit der Mitteilung der Alarmmeldung an den Verbraucher ist z. B. eine übliche Nachrichtengenerierung, wie z. B. über SMS, Pager oder Mobilfunksystem.

Wenn keine Meldung an den Verbraucher stattfindet oder der Verbraucher diese Meldung nicht überprüfbar zur Kenntnis nimmt, hat der Energieversorger auch die Möglichkeit, eine Wartungsperson direkt zum Verbraucher hinzuschicken, um diesen Störfall zu untersuchen.

Die Erfindung ist nicht unmittelbar auf die Unterbrechung der Stromversorgung an einem Energiezähler beschränkt, sondern nach einer weiteren technischen Lehre der vorliegenden Erfindung ist vorgesehen, dass der Energiezähler selbst als Monitor für Störungsfälle fungiert. Dies bedeutet, weil ohnedies nach einem erfindungswesentlichen Merkmal ein Gaszähler im Energiezähler angeordnet werden könnte, auch die Möglichkeit besteht, dass bei Ermittlung oder Überschreitung eines bestimmten Gaspegels eine Alarmmeldung an den Energieversorger erfolgt, ohne dass der Energieversorger den Energiezähler abschaltet. Die Alarmmeldung kann z. B. beinhalten, dass Gasgeruch in der Umgebung des Energiezählers festgestellt wurde und die beim Energieversorger eintreffende Alarmmeldung wird dann dazu genutzt, den Auslösefaktor des Gasaustrittes zu ermitteln und eventuell auch stillzulegen. Beispiele, bei denen bei einer Störung keine Abschaltung ausgelöst wird, sind nicht Teil der Erfindung.

Eine solche Alarmmeldung kann dann als Steuergröße verwendet werden, indem z. B. vom Energieversorger ein Abschaltimpuls an einen Gaszähler gegeben wird, der ein ansteuerbares Gasventil aufweist, um so mit der im Energiezähler generierten Störmeldung ein anderes Aggregat abzuschalten.

Neben der Abschaltung eines Gaszählers, der eine bidirektionale Datenverbindung zum Energieversorger aufweisen kann, gibt es auch noch andere Aggregate, die über eine Alarmmeldung, die im Energiezähler generiert wird, steuerbar sind. Es handelt sich hierbei um Fernwärmeaggregate und Wasserzähler.

Bei allen Anwendungsfällen ist es deshalb neu und erfindungswesentlich, dass der Energiezähler lediglich als Monitor benutzt wird und hierbei nicht vorausgesetzt wird, dass er am Unterbrecher ansteuert.

Die Erfassung der verbraucherseitigen Störgrößen durch eine drahtgebundene oder drahtlose Kommunikationsverbindung zwischen dem Verbraucher und dem Energieversorger hat den weiteren Vorteil, dass der Energieversorger die Störgrößen lückenlos dokumentieren kann und ein Nachweis geführt werden kann, wann und in welchem Zeitraum eine Störgröße zu einer verbraucherseitigen Abschaltung geführt hat.

Es ist besonders zweckmäßig, das Abschaltsignal, welches beim Energieversorger erzeugt wird, über die gleiche Stromleitung zu leiten, die auch der Energieversorgung auf der Verbraucherseite dient. Es handelt sich dabei um die bekannte PLC-Powerline-Technologie.

Es können jedoch auch drahtgebundene, andere Signalübertragungen verwendet werden, wie z. B. eine LAN-Übertragung oder Funktechnologien, insbesondere WLAN oder MBus oder Mobilfunktechnologien unter Benutzung des GSM-Netzes, wie z. B. GPRS oder LTE.

Es ist auch möglich, dass der Energieversorger in einer ersten Alarmstufe zunächst auch nur eine Alarmmeldung an den Verbraucher abgibt, die bei ihm über verschiedene Empfangstechnologien empfangen werden kann, wie z.B. auf dem Mobiltelefon, dem Pager oder als SMS oder dergleichen.

In einer zweiten Alarmstufe kann dann der Energieversorger den Unterbrecher im Verteilerschrank ansteuern und entweder die Energiezufuhr zum Verbraucher vollständig unterbrechen oder einschränken.

Für die Erfassung der Störgrößen können bekannte Sensoren verwendet werden, wie z. B. Temperaturfühler, Feuchtefühler, Gassensoren, Wasserstandssensoren, CO2-Sensoren und dergleichen mehr.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.

Soweit einzelne Gegenstände als "erfindungswesentlich" oder "wichtig" bezeichnet sind, bedeutet dies nicht, dass diese Gegenstände notwendigerweise den Gegenstand eines unabhängigen Anspruches bilden müssen. Dies wird allein durch die jeweils geltende Fassung des unabhängigen Patentanspruches bestimmt.

Im Folgenden wird die Erfindung anhand von einer, lediglich einen Ausführungsweg darstellenden Zeichnung näher erläutert. Hierbei gehen aus der Zeichnung und ihrer Beschreibung weitere erfindungswesentliche Merkmale und Vorteile der Erfindung hervor.

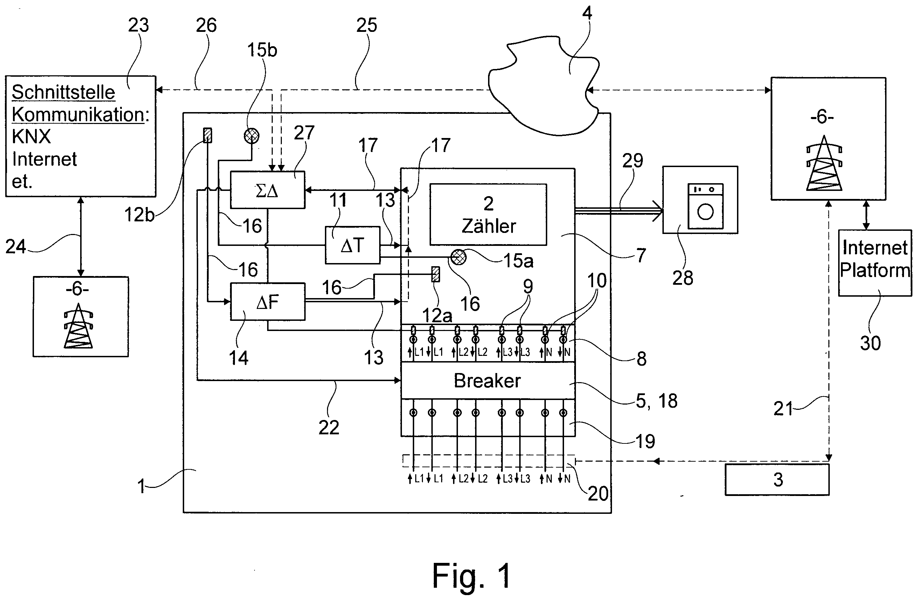

In Figur 1 ist schematisiert ein Blockschaltbild eines erfindungsgemäßen Energiezählers mit Unterbrecher dargestellt.

Der Verbraucher 28 wird über lediglich schematisiert dargestellte Stromleitungen 29 von einem Energiezähler 2 mit Strom versorgt, der in einem Verteilerschrank 1 angeordnet ist.

Im Energiezähler 2 ist ein Unterbrecher 5 angeordnet, der bevorzugt zur Unterbrechung aller drei Stromphasen geeignet ist.

Die Anschlussleiste 20 hat eine Anzahl von Stromein- und -ausgängen, wobei für jede Leitung L1, L2, L3 und N jeweils ein Pfeil gezeichnet ist, der in den Zähler hinein zeigt und der als Eingang bezeichnet wird, während für die gleiche Leitung auch ein Pfeil angegeben ist, der nach außen zeigt und den Ausgang des Zählers darstellt.

Die Ausgänge L1, L2 und L3 sowie N gehen zur Kundenseite und bilden die kundenseitige Energieversorgung.

Wenn der Unterbrecher vorhanden ist, wie es nach dem Gegenstand des unabhängigen Patentanspruches 1 vorgesehen ist, werden deshalb nur die Ausgänge L1, L2, L3 und N unterbrochen.

Sinngemäß gilt diese Zeichnung nach Figur 1 auch für einen üblichen Wechselstromzähler, wobei jedoch in der Abbildung ein Drehstromzähler dargestellt ist.

Ein Wandlerzähler hätte wiederum ein anderes Anschlussfeld, wobei für alle Zählertypen gilt, dass erfindungsgemäß lediglich vorgesehen ist, dass die zum Verbraucher hinführenden Leitungen abgeschaltet werden.

Sofern es sich um Wandlerzähler handelt, ist jedoch eine Abschaltung eher nicht vorgesehen.

In diesem Fall wirkt der Energiezähler lediglich als Monitor, der mit seinen eingebauten oder im Umgebungsbereich angeordneten Sensoren eine Überwachungseinrichtung bildet, die von der Seite des Energieversorgers abgefragt werden oder als selbständige Alarm- oder Störfallmeldung an den Energieversorger geschickt werden.

In Figur 1 ist lediglich noch ein Internetportal 30 eingezeichnet, welches vom Energieversorger 6 mit Daten versorgt wird und in dem gegebenenfalls die Alarmmeldungen angezeigt und vom Verbraucher abfragbar sind.

Für die neuartige Smart-Meter-Technologie der vorliegenden Erfindung ist erstmals im Haushalt ein Gerät vorgesehen, welches dauernd online ist oder sein kann und sämtliche Störgrößen in der Umgebung des Energiezählers oder im Energiezähler selbst erfasst und gegebenenfalls Alarmmeldungen generiert oder auch selbst eine Unterbrechung der Störgrößen generierenden Aggregate einleitet.

Die ausgangsseitigen Stromleitungen 9 sind in einem Anschlussfeld 8 angeordnet und auch die Null-Leiter 10 können unterbrochen werden.

Die Eingangsseite des Unterbrechers 5 wird ebenfalls durch ein Anschlussfeld 19 gebildet, an das über eine Anschlussleiste 20 die Stromphasen und Nullleiter zugeführt werden.

Die Zuführung erfolgt - wie lediglich schematisiert dargestellt - über Energieleitungen 21, die mit dem Energieversorger 6 verbunden sind.

Es ist nur beispielhaft dargestellt, dass mit dem Übertragungsmodus 3 auch das Signal für die Ansteuerung des Unterbrechers 5 über die Energieleitungen 21 übertragen werden kann.

Es ist dargestellt, dass im Zählergehäuse 7 des Energiezählers 2 selbst Sensoren 12a, 12b angeordnet sind, wobei der Sensor 12a beispielsweise als Feuchtesensor und der Sensor 15a als Temperatursensor ausgebildet sein kann.

Somit wird unmittelbar die Feuchte und die Temperatur am Energiezähler 2 oder im Innenraum des Energiezählers 2 erfasst.

Es ist ferner dargestellt, dass die weiteren Sensoren 12b und 15b auch im Verteilerschrank 1 angeordnet sein können. Sie können jedoch auch außerhalb des Verteilerschrankes 1 in dessen Umgebung angeordnet sein. Die Auswerteelektronik 27 kann hierbei im Energiezähler 2 selbst oder auch außerhalb angeordnet sein.

Die Sensoren 12, 15 sind jeweils über Leitungen 16 mit der zugeordneten Sensorschaltung 11, 14 verbunden, die ihrerseits über Ausgänge 13 mit einer Busleitung 17 verbunden sind, welche den Eingang für die Auswerteelektronik 27 bildet.

Dies erfolgt durch ein im Unterbrecher 5 angeordnetes Steuermodul 18, welches nicht näher dargestellte Schaltkontakte ansteuert, um die Weiterleitung von den an der Anschlussleiste 20 eingehenden Stromleitungen in Richtung auf das ausgangsseitige Anschlussfeld 8 abgehenden Stromleitungen zu unterbrechen.

In diesem beschriebenen Beispiel, das nicht unter die Ansprüche fällt, sorgt demnach die im Verteilerschrank 1 angeordnete Auswerteelektronik 27 für eine selbsttätige Ansteuerung des Unterbrechers 5.

Dies ist jedoch nur ein erstes Beispiel, wobei die Erfindung darin besteht, dass der Unterbrecher 5 das von ihm gebildete Signal über eine Kommunikationsleitung 25 und/oder einen drahtlosen Übertragungsmodus 4 (z. B. über Internet) dem Energieversorger 6 zuleitet und dieser über die Energieleitungen 21 und/oder über die Kommunikationsleitung 25 den Unterbrecher 5 ansteuert und somit die Energieversorgung zum Verbraucher 28 unterbricht.

Es ist ein alternativer weiterer Signalweg auf der linken Seite in Figur 1 dargestellt, der darin besteht, dass eine drahtgebundene Verbindung über die Kommunikationsleitung 26 vorgesehen ist und ein daran angeschlossener Router, ein internetfähiger Browser oder ein GSM-Modul eine drahtlose oder eine drahtgebundene Übertragung über die Leitung 24 zum Energieversorger 6 durchführt.

Bei dem lediglich als Kasten dargestellten Kommunikationsnetzwerk 23 kann es sich also um verschiedene drahtlose oder drahtgebundene Übertragungskanäle handeln.

Wichtig ist, dass nun erstmals die Möglichkeit geschaffen wird, dass der Energieversorger 6 im Falle einer verbraucherseitigen Störung die Möglichkeit hat, die verbraucherseitige Störung auf seiner Seite zu dokumentieren und bei Überschreitung bestimmter Störgrößen den Verbrauch des Verbrauchers 28 einzuschränken oder abzuschalten.

Die Erfindung sieht auch vor, dass der Energieversorger 6 durch ein von ihm erzeugtes Steuersignal den Unterbrecher 5 wieder einschalten kann, sodass die Energiezufuhr zum Verbraucher wieder hergestellt ist.

Die Erfindung umfasst demzufolge auch folgende Möglichkeiten:
1. Sensoren, die bei Gas- und Wasserzählern angebracht sind, werden durch den Energiezähler erfasst > Daten weitergeleitet. Spezifisch Alarmmeldung beispielsweise Gasgeruch und/der Wasserrohrbruch.
2. Was die Temperatur und Stromüberwachung direkt beim Energiezähler (mit und ohne Unterbrecher) betrifft so ist spezifisch festzuhalten das bei einem Drehstromzähler, der Strom und die Kontakttemperatur jeder Phase Eingangs- und Ausgangsseitig > erfasst - ausgewertet - weitergesendet werden kann. Bei einem Wechselstromzähler gilt dieses Prinzip für eine Phase.

### Zeichnungslegende

- 1: Verteilerschrank
- 2: Energiezähler
- 3: Übertragungsmodus
- 4: Übertragungsmodus (Internet)
- 5: Unterbrecher
- 6: Energie-Versorger
- 7: Zählergehäuse
- 8: Anschlussfeld
- 9: Stromleitungen
- 10: Null-Leiter
- 11: Sensorschaltung
- 12a: Sensor; 12b Sensor
- 13: Ausgang
- 14: Sensorschaltung
- 15a: Sensor; 15b Sensor
- 16: Leitung
- 17: Busleitung
- 18: Steuermodul
- 19: Anschlussfeld (von 5)
- 20: Anschlussleiste
- 21: Energieleitungen
- 22: Steuerleitung
- 23: Kommunikationsnetzwerk
- 24: Leitung
- 25: Kommunikationsleitung
- 26: Kommunikationsleitung
- 27: Auswerteelektronik
- 28: Verbraucher
- 29: Stromleitungen
- 30: Internetportal

## Patentansprüche

1. Verteilerschrank umfassend einen Energiezähler (2), einen Unterbrecher (5), eine Auswerteelektronik (27) und mindestens einen Sensor (12), wobei der Unterbrecher (5) zur Unterbrechung der Stromversorgung zu mindestens einem am Energiezähler (2) anschließbaren Verbraucher (28) eingerichtet ist, die Auswerteelektronik (27) zur Erfassung und Auswertung von Signalen des mindestens einen Sensors (12) eingerichtet ist, der Energiezähler (2) und der Unterbrecher (5) in dem Verteilerschrank (1) angeordnet sind und der Verteilerschrank (1) vorgesehen ist, beim Verbraucher positioniert zu sein, der mindestens eine Sensor (12) am oder im Verteilerschrank (1) und insbesondere am oder im Energiezähler (2) angeordnet ist und zur Erfassung einer Störgröße wie zum Beispiel die Überschreitung einer vorgegebenen Temperatur und/oder Feuchte und/oder Gasmenge und/oder Gaszusammensetzung geeignet ist, **dadurch gekennzeichnet, dass** die Auswerteelektronik (27) über mindestens einen Signalpfad umfassend mindestens eine Kommunikationsleitung (25, 26) mit einem entfernt des Energiezählers befindlichen Energie-Versorgers (6) verbindbar ist und der Unterbrecher (5) so eingerichtete ist, dass der Energieversorger (2) bei Erfassung der vorgegebenen Störgröße den Unterbrecher (5) über eine Energieleitung (21) oder eine der Kommunikationsleitungen (26) im Sinn einer Abschaltung des Verbrauchers (28) ansteuern kann.

2. Verteilerschrank nach Anspruch 1, **dadurch gekennzeichnet, dass** der Energiezähler (2) dazu eingerichtet ist, im Fall der Erfassung einer Störgröße das die Störgröße generierende Aggregat, z. B. einen Wasserzähler und/oder einen Gaszähler und/oder einen Fernwärmezähler abzuschalten.

3. Verteilerschrank nach Anspruch 1, **dadurch gekennzeichnet, dass** der Unterbrecher (5) dazu eingerichtet ist, alle Phasen der verbraucherseitigen Stromleitungen (29) und den Nullleiter abzuschalten.

4. Verteilerschrank nach einem der Ansprüche 1 bis 3, **dadurch gekennzeichnet, dass** der Signalpfad (26) zwischen der Auswerteelektronik (27) des verbraucherseitigen Verteilerschranks (1) zum Energieversorger (6) eine Internetverbindung ist.

5. Verteilerschrank nach einem der Ansprüche 1 bis 4, **dadurch gekennzeichnet, dass** die von dem mindestens einen Sensor (12) erfasste Störgröße außerhalb des Verteilerschranks (1), jedoch im Umgebungsbereich des Verbrauchers (28) erfassbar ist.

6. Verteilerschrank nach einem der Ansprüche 1 bis 5, **dadurch gekennzeichnet, dass** als Teil des Verteilerschranks (1) mehrere Sensoren (12a, 12b) zur Erfassung der Störgrößen vorgesehen sind, deren Signale in der Auswerteelektronik (27) verarbeitet und gewichtet werden.

7. Verteilerschrank nach einem der Ansprüche 1 bis 6, **dadurch gekennzeichnet, dass** als Störgrößen die Temperatur, und/oder die Feuchte, und/oder die Gasmenge und/oder die Gaszusammensetzung brennbarer Gase erfassbar sind.

8. Verteilerschrank nach einem der Ansprüche 1 bis 7, **dadurch gekennzeichnet, dass** der Verteilerschrank so eingerichtet ist, dass der Unterbrecher durch ein Signal des Energieversorgers wieder eingeschaltet werden kann.

## Claims

1. Distribution cabinet comprising an energy meter (2), an interrupter (5), evaluating electronics (27) and at least one sensor (12), wherein the interrupter (5) is arranged to interrupt the power supply to at least one consuming device (28) which is connectable to the energy meter (2), the evaluating electronics (27) are arranged to record and evaluate signals of the at least one sensor (12), the energy meter (2) and the interrupter (5) are arranged in the distribution cabinet (1) and the distribution cabinet (1) is provided to be positioned in the consuming device, the at least one sensor (12) is arranged on or in the distribution cabinet (1) and in particular on or in the energy meter (2) and is suitable for recording a disturbance variable, such as for example exceeding a predetermined temperature and/or humidity and/or gas quantity and/or gas composition, **characterised in that** the evaluating electronics (27) are connectable to an energy supplier (6) located remotely from the energy meter via at least one signal path comprising at least one communication line (25, 26) and the interrupter (5) is arranged so that the energy supplier (2) can control the interrupter (5) when recording the predetermined disturbance variable via an energy line (21) or one of the communication lines (26) in the sense of disconnecting the consuming device (28).

2. Distribution cabinet according to claim 1, **characterised in that** the energy meter (2) is arranged to disconnect the unit generating the disturbance variable, for example a water meter and/or a gas meter and/or a remote heat counter, in the event of recording a disturbance variable.

3. Distribution cabinet according to claim 1, **characterised in that** the interrupter (5) is arranged to disconnect all phases of the power lines (29) on the consuming-device side and the neutral conductor.

4. Distribution cabinet according to one of claims 1 to 3, **characterised in that** the signal path (26) between the evaluating electronics (27) of the distribution cabinet (1) on the consuming-device side and the energy supplier (6) is an Internet connection.

5. Distribution cabinet according to one of claims 1 to 4, **characterised in that** the disturbance variable recorded by the at least one sensor (12) is recordable outside of the distribution cabinet (1), but in the surrounding area of the consuming device (28).

6. Distribution cabinet according to one of claims 1 to 5, **characterised in that** several sensors (12a, 12b) are provided for recording the disturbance variables, the signals of which are processed and weighted in the evaluating electronics (27), as part of the distribution cabinet (1).

7. Distribution cabinet according to one of claims 1 to 6, **characterised in that** the temperature, and/or the humidity, and/or the gas quantity and/or the gas composition of combustible gases are recordable as disturbance variables.

8. Distribution cabinet according to one of claims 1 to 7, **characterised in that** the distribution cabinet is arranged so that the interrupter can be reconnected by a signal from the energy supplier.

## Revendications

1. Armoire de distribution comprenant un compteur d'énergie (2), un interrupteur (5), une électronique d'analyse (27) et au moins un capteur (12), dans laquelle l'interrupteur (5) est installé pour interrompre l'alimentation en courant d'au moins un consommateur (28) apte à être raccordé au compteur d'énergie (2), l'électronique d'analyse (27) est installée pour détecter et analyser des signaux du au moins un capteur (12), le compteur d'énergie (2) et l'interrupteur (5) sont disposés dans l'armoire de distribution (1) et l'armoire de distribution (1) est prévue pour être positionnée à proximité du consommateur, le au moins un capteur (12) est disposé sur ou dans l'armoire de distribution (1) et en particulier sur ou dans le compteur d'énergie (2) et est apte à détecter une grandeur perturbatrice comme par exemple le dépassement d'une température et/ou humidité et/ou quantité de gaz et/ou composition de gaz prédéfinies, **caractérisée en ce que** l'électronique d'analyse (27) est apte à être raccordée par au moins un chemin de signal comprenant au moins une ligne de communication (25, 26) à un fournisseur d'énergie (6) à distance du compteur d'énergie, et l'interrupteur (5) est installé de telle sorte que le fournisseur d'énergie (2), lors de la détection de la grandeur perturbatrice prédéfinie, puisse commander l'interrupteur (5) via une ligne d'énergie (21) ou l'une des lignes de communication (26) afin de déconnecter le consommateur (28).

2. Armoire de distribution selon la revendication 1, **caractérisée en ce que** le compteur d'énergie (2) est installé pour déconnecter, en cas de détection d'une grandeur perturbatrice, l'unité générant la grandeur perturbatrice, par exemple un compteur d'eau et/ou un compteur de gaz et/ou un compteur de chaleur.

3. Armoire de distribution selon la revendication 1, **caractérisée en ce que** l'interrupteur (5) est installé pour arrêter toutes les phases des lignes de courant côté consommateur (29) et le conducteur neutre.

4. Armoire de distribution selon l'une des revendications 1 à 3, **caractérisée en ce que** le chemin de signal (26) entre l'électronique d'analyse (27) de l'armoire de distribution côté consommateur (1) et le fournisseur d'énergie (6) est une connexion Internet.

5. Armoire de distribution selon l'une des revendications 1 à 4, **caractérisée en ce que** la grandeur perturbatrice détectée par le au moins un capteur (12) est apte à être détectée à l'extérieur de l'armoire de distribution (1), mais dans la zone environnante du consommateur (28).

6. Armoire de distribution selon l'une des revendications 1 à 5, **caractérisée en ce que** comme élément de l'armoire de distribution (1), on prévoit plusieurs capteurs (12a, 12b) pour détecter les grandeurs perturbatrices, dont les signaux sont traités et pondérés dans l'électronique d'analyse (27).

7. Armoire de distribution selon l'une des revendications 1 à 6, **caractérisée en ce que** comme grandeurs perturbatrices peuvent être détectées la température et/ou l'humidité et/ou la quantité de gaz et/ou la composition de gaz combustibles.

8. Armoire de distribution selon l'une des revendications 1 à 7, **caractérisée en ce que** l'armoire de distribution est installée de telle sorte que l'interrupteur puisse être remis en marche par un signal du fournisseur d'énergie.
